# EUROPEAN PATENT APPLICATION

(11) **EP 4 838 241 A1**
(43) Date of publication of application: **11.11.2026**
(21) Application number: 25174459.5
(22) Date of filing: 06.05.2025
(51) Int. Cl.: G01R 31/42, G01R 31/64

(54) **METHOD AND APPARATUS FOR ESTIMATING STRESS LEVEL OF CAPACITOR ASSEMBLY**

(71) Applicant: ABB SCHWEIZ AG, 5400 Baden (CH)
(72) Inventor: Hämäläinen, Juho, 00380 Helsinki (FI); Mielonen, Asko, 00380 Helsinki (FI); Haapaniemi, Rasmus, 00380 Helsinki (FI); Mustajärvi, Patrik, 00380 Helsinki (FI)
(74) Representative: Kolster Oy Ab

(57) **Abstract**

A method and apparatus for estimating a stress level of a capacitor assembly (C). The method comprises obtaining at least one value of at least one operating parameter related to the capacitor assembly (C), determining an estimated lifetime of the capacitor assembly (C) on the basis of the obtained at least one value and determining an instantaneous stress level of the capacitor assembly (C) on the basis of the determined estimated lifetime of the capacitor assembly (C) and a predetermined designed lifetime of the capacitor assembly (C).

## Description

### TECHNICAL FIELD

The present invention relates to a method and an apparatus for estimating a stress level of a capacitor assembly.

### BACKGROUND

Capacitors, such as DC capacitors, used in an electric drive for example, may be replaced based on e.g. a service timetable at predefined times. In case capacitors are used in a demanding application, there may be an increased risk of a capacitor failure in the drive. It is also possible that the operating conditions of the capacitors are varying over time or change considerably for some external reason, for instance. In such a case the service timetable might not be appropriate any longer and the capacitors might just wear out and fail prematurely. This may result in an inoperative device and disrupted production, for example

The capacitors could be replaced more often to reduce such a risk but then the resulting maintenance time and cost would increase accordingly.

### BRIEF DESCRIPTION

An object of the present invention is thus to provide a method and an apparatus for implementing the method so as to overcome the above problem or at least to alleviate the problem. The object of the invention is achieved by a method, a computer program product and an apparatus which are characterized by what is stated in the independent claims. The preferred embodiments of the invention are disclosed in the dependent claims.

The invention is based on the idea of obtaining at least one value of at least one operating parameter related to the capacitor assembly, determining an estimated lifetime of the capacitor assembly on the basis of the obtained at least one value and determining an instantaneous stress level of the capacitor assembly on the basis of the determined estimated lifetime of the capacitor assembly and a predetermined designed lifetime of the capacitor assembly.

An advantage of the solution of the invention is that it enables to assess how stressful an operation is or has been for a capacitor assembly. Consequently, it can be evaluated if there is a need to replace the capacitor(s) of the capacitor assembly.

### BRIEF DESCRIPTION OF THE DRAWINGS

In the following the invention will be described in greater detail by means of preferred embodiments with reference to the accompanying drawings, in which
Figure 1 shows an electric system according to an embodiment;
Figure 2 shows an electric system according to an embodiment;
Figure 3 shows a flow diagram according to an embodiment;
Figure 4 shows a diagram according to an embodiment; and
Figure 5 shows a block diagram according to an embodiment.

### DETAILED DESCRIPTION

The following embodiments are exemplary. Embodiments described herein may be implemented in various manners other than the ones described below. Although the description may refer to "an", "one", or "some" embodiment(s) in several locations, this does not necessarily mean that each such reference is to the same embodiment(s), or that the feature only applies to a single embodiment, for example. Single features of different embodiments may also be combined to provide other embodiments. When a particular feature, structure, or characteristic is described in connection with an embodiment, it is submitted that it is within the knowledge of one skilled in the art to affect such feature, structure, or characteristic in connection with other embodiments whether or not explicitly described.

Furthermore, terms such as "comprises", "comprising", "has", "having", "includes" and/or "including" should be understood as not limiting the described embodiment(s) to consist of only those features, elements, components and/or combinations thereof that have been mentioned, and such embodiment(s) may also contain features, elements, components and/or combinations thereof that have not been specifically mentioned. Moreover, terms such as "connected" and "coupled", are used to mean connected or coupled directly or indirectly (i.e. via one or more elements).

Reference numbers, in the description and/or in the claims, serve to illustrate the embodiments with reference to the drawings, without limiting the embodiments to these examples only. Generally, all terms and expressions used should be interpreted broadly and they are intended to illustrate, not to restrict, the embodiments. The figures only show components necessary for understanding the various embodiments. The number, shape and/or configuration of the various elements, and generally their implementation, could vary from the examples shown in the figures.

Moreover, it should be understood that although terms such as "first," "second" and the like may be used herein to describe various elements, these elements should not be limited by these terms. Such terms are only used to distinguish one element from another. For example, a first element could be termed a second element, and similarly, a second element could be termed a first element, without departing from the scope of example embodiments. As used herein, expression "and/or" includes any and all combinations of one or more of the listed terms.

Different embodiments and examples may be described below using single units, models, equipment and memory, without restricting the embodiments/examples to such a solution. Concepts called cloud computing and/or virtualization may be used. The virtualization may allow a single physical computing device to host one or more instances of virtual machines that appear and operate as independent computing devices, so that a single physical computing device can create, maintain, delete, or otherwise manage virtual machines in a dynamic manner. It is also possible that device operations will be distributed among a plurality of servers, nodes, devices and/or hosts. In possible cloud computing network devices, computing devices and/or storage devices may provide shared resources. Some other technology advancements, such as Software-Defined Networking (SDN), may cause one or more of the functionalities described below to be migrated to any corresponding abstraction or apparatus or device. Therefore, all words and expressions should be interpreted broadly, and they are intended to illustrate, not to restrict, the embodiment in question.

The application of the embodiments described herein is generally not, unless otherwise stated, restricted to any specific system, but they may be applied in various electric power systems such as electric power converter systems comprising one or more electric power converters. In addition, the use of the embodiments described herein is not restricted to any system utilizing a specific basic (fundamental) frequency or to any specific voltage level(s), for example.

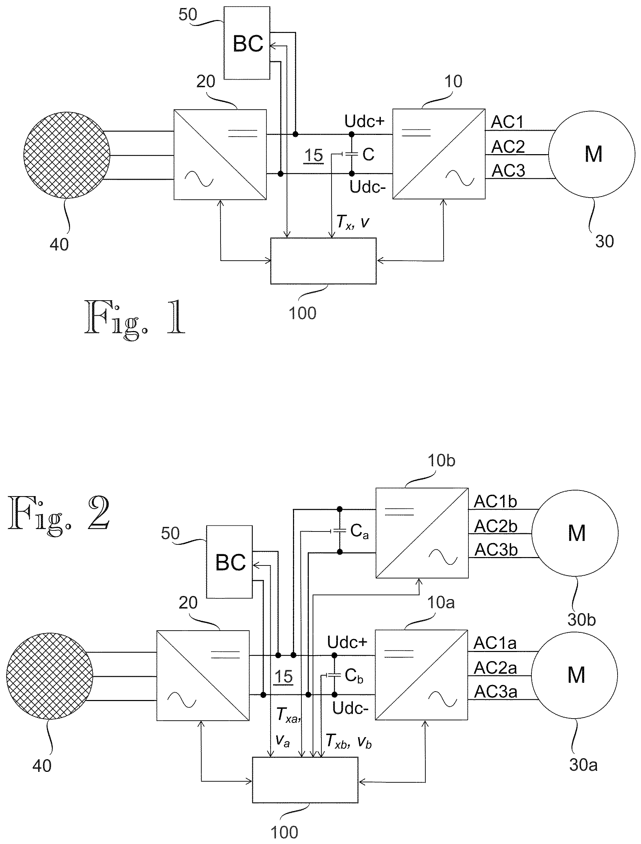

Figure 1 illustrates an example of an electric power converter system, such as an electric drive system, for example. Term 'electric drive' (or AC drive) herein generally refers to an electronic apparatus (device, arrangement, system), which may be used to regulate the performance of an electric motor, thus constituting a motor drive, i.e. an adjustable speed drive, or another kind of load, for example. An electric drive may control the power, frequency and/or current supplied to the load, for instance. An electric drive and an electric motor, or another kind of load, controlled by the electric drive may form an electric drive system. An electric drive may comprise one or more electric power converter units or modules, such as rectifiers, inverters and/or frequency converters, for example. In the example of Figure 1, the electric power converter system comprises a first electric power converter 10 and a second electric power converter 20 connected to each other by a DC link (DC intermediate circuit) 15 with a positive pole Udc+ and a negative pole Udc-. Such a DC link 15 could also have more than two poles. One or both of the exemplary electric power converters 10, 20 could be bidirectional, i.e. capable of functioning both as a rectifier and as an inverter. In other words, one or both of the exemplary electric power converters 10, 20 could be configured to rectify alternating current (AC) into direct current (DC) and convert direct current into alternating current depending on its mode of operation, for example. It is also possible that one or both of the exemplary electric power converters 10, 20 is/are unidirectional, i.e. configured to operate only as an inverter or only as a rectifier, for instance. The exemplary electric power converters 10, 20 are three-phase converters having three AC poles and two DC poles. However, instead of three phases, the electric power converters 10, 20 could have another number of AC phases, e.g. one, two, three, four, five, six or more. Similarly, the electric power converters 10, 20 could have more than two DC poles, i.e. they could be e.g. three-level (or higher level) converters, for example. Herein term 'inverter' generally refers to an electronic device or circuitry that is able to convert direct current to alternating current, i.e. which can operate at least as a DC-to-AC converter. An example of the inverter is a semiconductor bridge implemented by means of controllable semiconductor switches, such as IGBTs (Insulated-Gate Bipolar Transistor) or FETs (Field-Effect Transistor), which are controlled according to a modulation or control scheme used. As an example, a control of an electric motor may be implemented by means of the electric drive in such a manner that the motor implements a desired speed and/or torque instruction, for example. Examples of control methods for electric drives include frequency control, flux vector control and direct torque control, for example. Moreover, term 'rectifier' generally refers to an electronic device or circuitry, for example, that is able to convert alternating current to direct current, i.e. which can operate at least as an AC-to-DC converter.

In the example of Figure 1, the first and second electric power converters 10, 20 could form an electric drive configured to feed an electric machine, such as an electric motor, 30 from an AC source, such as an AC network (grid) 40 and/or to transfer electrical energy from the electric machine 30 to the DC link 15 and/or to the AC network 40. Examples of electric motors include an asynchronous AC motor, e.g. an induction motor, and a synchronous AC motor including non-excited motors, such as a reluctance motor, a hysteresis motor and a permanent magnet motor, for example. The AC network 40 could be a three-phase AC network. The AC connection of the first electric power converter 10 in the example is a three-phase connection with three AC poles AC1, AC2, AC3. In the example the AC connection AC1, AC2, AC3 of the first electric power converter 10 may function as an AC output, if/when the first electric power converter 10 operates as an inverter but if the first electric power converter 10 is configured for bidirectional operation, it is also possible that the AC connection AC1, AC2, AC3 of the first electric power converter 10 may also function as an AC input for feeding energy from the electric machine 30 towards the DC link 15, for example. The first and second electric power converters 10, 20 could thus form a frequency converter such that the first electric power converter 10 is configured to operate at least as an inverter and the second electric power converter 20 is configured to operate at least as a rectifier or vice versa, for example.

The exemplary system of Figure 1 further shows a capacitor assembly (capacitive circuit) C connected between the DC poles Udc+, Udc- of the DC link 15. The capacitor assembly C may comprise one or more capacitors (capacitor elements or components). The one or more capacitors could be e.g. electrolytic capacitors, such as aluminium electrolytic capacitors, and/or of any other type suitable for the particular application. An example of such a capacitor assembly is a capacitor bank. In case the capacitor assembly C comprises two or more capacitors, such capacitors may be connected in series and/or in parallel with each other, for instance. The capacitor assembly C, or at least a part thereof, could be physically located within one or both of the first and second electric power converters 10, 20, e.g. within a common housing, or be a separate entity with its own housing or enclosure (not shown in the figures), for example. The capacitor assembly C may be provided with a suitable cooling arrangement, such as air and/or liquid cooling. According to an embodiment, such a capacitor assembly could alternatively be connected to an AC circuit, e.g. to the AC poles of the first electric power converter 10 or to the AC poles of the second electric power converter 20. As an example, the capacitor assembly could be included in an AC filter (not shown separately in the figures), such as an AC input filter and/or an AC output filter, for example. Such AC input filter and/or an AC output filter could be a separate element or included in the first electric power converter 10 or in the second electric power converter 20, for example.

The exemplary system of Figure 1 further shows a brake chopper (BC) 50. Generally, a brake chopper, or braking chopper, may be used in connection with electric systems and devices, such as electric power converters 10, 20, for dissipating regenerated energy that cannot be fed back to the supplying network 40, for instance. As an example, in case a motor 30 controlled by a frequency converter 10, 20 having a DC voltage intermediate circuit 15 is rotated by a (mechanical) load connected to the motor, the motor can act as a generator and feed power back to the frequency converter. If the rectifier of the frequency converter is not configured or able to feed the regenerated energy back to a network supplying the frequency converter, the voltage of the intermediate circuit 15 starts to increase. When the voltage of the intermediate circuit 15 has increased to a predetermined limit, e.g. higher than a nominal voltage of the intermediate circuit, the brake chopper 50 connected to the frequency converter 10, 20 may be activated and used to convert excess electrical energy into heat in a brake resistance (not shown separately in the figure) thereof in order to reduce the voltage of the intermediate circuit. The brake chopper 50 may thus be used to reduce, or generally control, the voltage of the DC link 15 until it is within acceptable limits with respect to the nominal voltage, for example.

The exemplary system of Figure 1 further shows an arrangement (e.g. apparatus, device, unit, system) 100, such as a control and/or monitoring arrangement, which may be used for implementing the functionality, or at least some of it, according to the various embodiments described herein. The arrangement 100 may be located at a same site or location as the one or more elements of the electric power converter system or at another site, such as a remote site. The arrangement 100 could also be located within the first electric power converter 10, the second electric power converter 20 and/or the capacitor assembly C or otherwise within or in connection with an enclosure thereof, for example. As an example, the arrangement 100 could also comprise a control arrangement of the first electric power converter 10 and/or of the second electric power converter 20 and/or of the brake chopper 50 and could thus be configured to control the electric power converter system and/or components thereof. The arrangement 100 may comprise suitable I/O (Input-Output) means for communicating with or at least receiving data from e.g. the first electric power converter 10 and/or from the second electric power converter 20 and/or from the brake chopper 50. Moreover, as shown in the example of Figure 1, the arrangement 100 may be configured to obtain data, such as measuring data, from the capacitor assembly C and/or data relating to the capacitor assembly C e.g. by receiving such data from another entity. The arrangement 100 could also comprise measuring means, such as one or more sensors, to obtain values of one or more quantities utilized in the various embodiments described herein by measuring, for example. Such measuring means could comprise e.g. temperature, voltage and/or current measuring sensors. Generally, the arrangement 100 implementing any functionality of the embodiments described herein, may be implemented by utilizing electric power converter's 10, 20 own measurements, external measurements or as a combination of both. Any signal processing and software implementation could be also implemented inside or within one or more of the electric power converters 10, 20 or by some other external device(s), such as a gateway(s), and/or by utilizing cloud computing, for example. To achieve this, system initial values, measurements and/or operating point information could be given to the arrangement 100 implementing any functionality of the embodiments described herein from each source of capacitor current, for example. Also, information about ambient temperature, fan speed and/or other relevant cooling properties or information may be provided to the arrangement 100 implementing any functionality of the embodiments described herein from respective source(s) of such information, such as the device in question or a control entity thereof.

Figure 2 illustrates another example of an electric power converter system which corresponds to that of Figure 1 but additionally comprises two first electric power converters 10a, 10b connected in parallel to the DC link 15. There could be even more than two such parallel first electric power converters 10a, 10b. Additionally or alternatively, there could be two or more parallel second electric power converters 20 connected between the AC network 40 and the DC link 15. It is also possible that the DC link 15 is connected to one or more further AC and/or DC power systems, such as power network(s) and/or energy storage system(s), via one or more further power converters, for example. The two first electric power converters 10a, 10b in the example are connected to their respective electric machines 30a, 30b. In the example of Figure 2, the multiple first electric power converters 10a, 10b may thus share the common DC link 15 in manner known per se. The multiple first electric power converters 10a, 10b may have their own respective capacitor assemblies Cₐ, C_{b} as illustrated. In the example of Figure 2, the arrangement 100 is common to both of the multiple capacitor assemblies Cₐ, C_{b} but there could also be a dedicated separate arrangement 100 for each of the multiple capacitor assemblies Cₐ, C_{b}, for example. Any embodiments described in connection with the example system of Figure 1 may be implemented in an essentially similar manner also in the example system of Figure 2. For example that capacitor assembly specific values for capacitor assembly Cₐ are marked with specifier a while capacitor assembly specific values for capacitor assembly C_{b} are marked with specifier b.

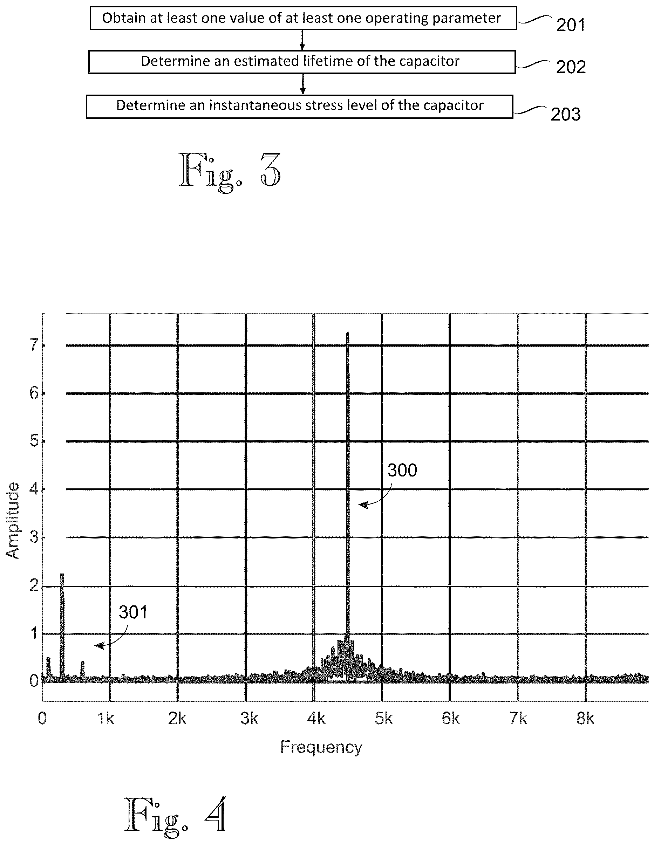

According to an embodiment, as exemplified in Figure 3, a method for estimating a stress level of the capacitor assembly C, Cₐ, C_{b} is provided. The method comprises a) obtaining 201 at least one value of at least one operating parameter related to the capacitor assembly C, Cₐ, C_{b}, b) determining 202 an estimated lifetime of the capacitor assembly C, Cₐ, C_{b} on the basis of the obtained at least one value, and c) determining 203 an instantaneous stress level of the capacitor assembly C, Cₐ, C_{b} on the basis of the determined estimated lifetime of the capacitor assembly and a predetermined designed lifetime of the capacitor assembly. According to an embodiment, the method further comprises repeating steps a) to c) two or more times over a period of time and determining a cumulative stress level of the capacitor assembly C, Cₐ, C_{b} over the period of time on the basis of the two or more instantaneous stress levels determined over the period of time. According to an embodiment, steps a) to c) may be repeated essentially continuously or at predetermined intervals over the period of time, for example. According to an embodiment, the method further comprises controlling an apparatus comprising the capacitor assembly C, Cₐ, C_{b} or connected to the capacitor assembly C, Cₐ, C_{b} on the basis of the determined stress level of the capacitor assembly C, Cₐ, C_{b}.

According to an embodiment, the determining of the estimated lifetime of the capacitor assembly C, Cₐ, C_{b} may be based on a predetermined nominal lifetime of the capacitor assembly and at least one stress factor (coefficient) based on the at least one operating parameter. The predetermined nominal (rated) lifetime of the capacitor assembly may be provided e.g. by a manufacturer of the capacitor assembly (or of the one or more capacitors of the capacitor assembly) or be determined in another way. According to an embodiment, the at least one stress factor may comprise a temperature factor and the at least one operating parameter may comprise at least one operating temperature parameter of the capacitor assembly. Additionally or alternatively, the at least one stress factor may comprise a current factor and the at least one operating parameter may comprise at least one operating current parameter of the capacitor assembly. Additionally or alternatively, the at least one stress factor may comprise a voltage factor and the at least one operating parameter may comprise at least one operating voltage parameter of the capacitor assembly. Some possible examples are provided in the following disclosure.

According to an embodiment, the determining of the estimated lifetime of the capacitor assembly C, Cₐ, C_{b} may be based on the predetermined nominal lifetime of the capacitor assembly and the at least one stress factor may be calculated as a product of the predetermined nominal lifetime of the capacitor assembly and the at least one stress factor. An example equation for calculating the estimated lifetime (total lifetime) *Lₓ* of the capacitor assembly may thus be written as: ${L}_{x} = {L}_{0} ∗ {K}_{T} ∗ {K}_{R} ∗ {K}_{V} = {L}_{0} ∗ {2}^{\frac{{T}_{0} - {T}_{x}}{10}} ∗ {2}^{\frac{Δ {T}_{0} - Δ T}{10}} ∗ {\left(\frac{{V}_{0}}{{V}_{x}}\right)}^{Z}$ (1) where:
*L*₀ is the nominal (rated) lifetime of the capacitor assembly
*K_{T}* is a temperature factor
*K_{R}* is a current factor
*Kᵥ* is a voltage factor
*T*₀ is a nominal (rated) ambient temperature of the capacitor assembly
*Tₓ* is an operating ambient temperature of the capacitor assembly
Δ*T*₀ is a core to ambient temperature difference in the capacitor assembly at a nominal load
Δ*T* is a core to ambient temperature difference caused by ripple current of the capacitor assembly
*V*₀ is a nominal (rated) operating voltage of the capacitor assembly
*Vₓ* is an actual operating voltage of the capacitor assembly
*Z* is an exponent related to a voltage coefficient of the capacitor assembly, provided e.g. by manufacturer a manufacturer of the capacitor assembly.

Example equation 1 above includes three factors, namely the temperature factor *K_{T}*, the current factor *K_{R}* and the voltage factor *Kᵥ.* However, it is also possible to use only any one or two of these factors, i.e. to omit one or more of these factors from equation 1, and/or have one or more additional factors, for example.

According to an embodiment, the temperature factor *K_{T}* may be determined by at least one operating temperature parameter of the capacitor assembly, such as the operating ambient temperature. Thus, the temperature factor *K_{T}* may be an ambient temperature coefficient. According to an embodiment, the temperature factor *K_{T}* may be calculated e.g. as ${2}^{\frac{{T}_{0} - {T}_{x}}{10}}$. However, the temperature factor *K_{T}* could be also calculated or determined in some other way. The value of *T*₀, i.e. the nominal (rated) ambient temperature of the capacitor assembly or corresponding data may be provided e.g. by a manufacturer of the capacitor assembly (or of the one or more capacitors of the capacitor assembly). The value of *Tₓ* (or *Tₓₐ, T_{xb}*), i.e. the operating ambient temperature of the capacitor assembly C, Cₐ, C_{b} may be a measured value obtained by or via a suitable measuring arrangement or obtained by receiving from another entity. As an example, the operating ambient temperature *Tₓ* of the capacitor assembly C, Cₐ, C_{b} may be a measured value of a cooling air (or other cooling medium) input temperature or generally any value indicative of an ambient temperature of the capacitor assembly C, Cₐ, C_{b}.

According to an embodiment, the voltage factor *K_{V}* may be determined by at least one operating voltage parameter of the capacitor assembly C, Cₐ, C_{b}, such as the capacitor assembly operating (DC) voltage. According to an embodiment, the voltage factor *K_{V}* may be calculated e.g. as ${\left(\frac{{V}_{0}}{{V}_{x}}\right)}^{Z}$*.* However, the voltage factor *K_{V}* could be also calculated or determined in some other way. The value of *Vₒ*, i.e. the nominal (rated) voltage of the capacitor assembly or corresponding data, and similarly the value of coefficient Z may be provided e.g. by a manufacturer of the capacitor assembly (or of the one or more capacitors of the capacitor assembly). The value of *Vₓ,* i.e. the operating voltage of the capacitor assembly C, Cₐ, C_{b}, which may correspond to the DC link voltage between the DC poles Udc+, Udc- of the DC link 15, may be a measured value obtained by or via a suitable measuring arrangement or obtained by receiving from another entity. As an example, the value of the operating voltage *Vₓ* of the capacitor assembly C, Cₐ, C_{b} may be readily available from the first electric power converter 10, 10a, 10b and/or from the second electric power converter 20, for example.

According to an embodiment, the current factor *K_{R}* may be determined by at least one operating current parameter of the capacitor assembly, such as a capacitor assembly current, or current component, causing temperature rise in the capacitor assembly C, Cₐ, C_{b}. According to an embodiment, the current factor *K_{R}* may be a ripple current coefficient. According to an embodiment, the current factor *K_{R}* may be calculated e.g. as ${2}^{\frac{Δ {T}_{0} - Δ T}{10}}$. However, the current factor *K_{R}* could be also calculated or determined in some other way. The value of Δ*T*₀*,* i.e. the core to ambient temperature difference in the capacitor assembly at a nominal (rated) load may be provided e.g. by a manufacturer of the capacitor assembly (or of the one or more capacitors of the capacitor assembly). The value of Δ*T*, i.e. the core to ambient temperature difference caused by ripple current of the capacitor assembly, may be determined as will be described in more detail in the examples below.

According to an embodiment, the calculation of the current factor *K_{R}* may include dividing currents flowing into and out of the capacitor assembly C, Cₐ, C_{b} suitably, e.g. in a predetermined manner, into two or more different frequency ranges e.g. based on their sources. Generally, low frequency currents may be caused at least mainly e.g. by commuting of a network side semiconductor bridge(s), which may be implemented e.g. by 6-pulse bridge, 12-pulse bridge, or any other passive rectifier, a regenerative rectifier unit etc. An assumption may be made that such devices are line commuting devices and do not produce high frequency switching in the semiconductors. In terms of current, the produced base frequency of current may be below about 1kHz range, e.g. for a 6-pulse semiconductor bridge in a 60Hz network, the base frequency is 60Hz * 6 = 360 Hz. Moreover, medium frequency currents could be considered currents possibly formed by e.g. semiconductor(s) switching in a range between about 1kHz and about 2kHz and may be generated e.g. by the possible brake chopper 50 switching in the intermediate circuitry 15. High frequency currents could be formed by semiconductor switching that takes place above a range of about 2kHz and could represent e.g. the switching performed by the motor (or other load) side inverter 10, 10a, 10b or by a network side inverter. It is noted, however, that the various current(s) of different frequencies could be categorized also in some other way and that the exemplary division into the low, medium and high frequency currents used in the present examples is only one possible alternative. There are several possible methods to estimate currents flowing into the capacitor assembly C, Cₐ, C_{b} including e.g. an indirect measurement of the voltage across the capacitor assembly C, Cₐ, C_{b} and an estimation method. Some possible examples are disclosed below. It is also noted that the electric system in which the capacitor assembly C, Cₐ, C_{b} is in could include many different types of combinations of sources of current which stresses the capacitor assembly C, Cₐ, C_{b}. The system may be a drive with only a rectifier and an inverter, or it may include different network side connection like an IGBT-supply unit and multiple inverters connected to DC-circuitry. In this situation, different sources of stressing factors need to be considered.

According to an embodiment, e.g. by recording the voltage *Vₓ* with sufficiently high sample rate and time, it is possible to calculate or generally determine what frequency components are present in the voltage, e.g. by taking Fourier transform of the recorded voltage, extract frequency amplitudes and divide by impedance of the DC-circuitry at each frequency, for example. By doing that it is possible to extract current (component) values flowing in the capacitor assembly C, Cₐ, C_{b} at each frequency of interest, for example. Instead of such indirect determination, the current, or current components, flowing in the capacitor assembly C, Cₐ, C_{b} could also be measured and analyzed by a direct measurement with a suitable measuring arrangement, for instance. According to an embodiment, another alternative is to estimate current values by monitoring individual semiconductor entities, such as the first electric power converter 10, 10a, 10b, the second electric power converter 20 and/or the brake chopper 50, working point, which are connected to the DC intermediate circuitry 15. According to an embodiment, yet another alternative of extracting currents flowing into and out of the capacitor assembly C, Cₐ, C_{b} may be to combine some aspects of the above alternatives.

According to an embodiment, a high frequency current (component) *I*_{*C,rms,*1} in the capacitor assembly C, Cₐ, C_{b} e.g. caused by an electric power converter 10, 10a, 10b, 20 operating as an inverter can be assessed by the following equation: ${I}_{C , rms , 1} = {I}_{s} \sqrt{2 ∗ M \left(\frac{\sqrt{3}}{4 π}+{cos}^{2}\left(φ\right)∗\left(\frac{\sqrt{3}}{π}-\frac{9}{16}M\right)\right)}$ (2) where:
*Iₛ* is an output current of the electric power converter, obtained e.g. from the electric power converter or by a measurement
M is a modulation index of the electric power converter, obtained e.g. from the electric power converter or by a measurement
cos (*φ*) is a cosine of a phase angle between current and voltage of the electric power converter, obtained e.g. from the electric power converter or by a measurement.

Equation 2 for the capacitor current *I*_{*C,rms,*1} described above may be generally valid for e.g. modulation techniques with zero-vectors in use. However, with active-zero vector modulation techniques, such as AZSPWM (Active Zero State Pulse-Width Modulation), may need to be modelled in another way. An example equation, which may be used to estimate a current (component) *I*_{{*C,rms,*1}} in the capacitor assembly C, Cₐ, C_{b} due to AZPWM, is: ${I}_{\left\{C, rms, 1\right\}} = {I}_{S} \sqrt{\frac{4 π - 6 \sqrt{3} cos \left(2φ\right) + 9 \sqrt{3} mcos \left(2φ\right)}{8 π} - \frac{9 {m}^{2} {cos}^{2} \left(φ\right)}{16}}$ (3) where:
*Iₛ* is an output current of the electric power converter, obtained e.g. from the electric power converter or by a measurement
*M* is a modulation index of the electric power converter, obtained e.g. from the electric power converter or by a measurement
cos (*φ*) is a cosine of a phase angle between current and voltage of the electric power converter, obtained e.g. from the electric power converter or by a measurement.

In electric power converter systems also other sources of high frequency current components might be present in the DC link 15 than just e.g. possible current component(s) produced by one or more electric power converters 10, 10a, 10b, 20 operating as an inverter. Such sources might include e.g. the possible brake chopper 50. According to an embodiment, a ripple current (component) *I_{R,AC,rms}* in the capacitor assembly C, Cₐ, C_{b} caused by the brake chopper 50 can be calculated by equation: ${i}_{R , AC , rms} = \sqrt{d - {d}^{2}} \frac{{V}_{x}}{{R}_{BR}}$ (4) where:
*d* is a duty cycle of brake chopper, obtained e.g. from the brake chopper or by a measurement
*Vₓ* is the DC link voltage corresponding to the operating voltage of the capacitor assembly C, Cₐ, C_{b}
*R_{BR}* is a predetermined resistance value of a brake resistor of the brake chopper.

An example of a spectrum of current components flowing through the capacitor assembly C, Cₐ, C_{b} in a system of Figure 1 is shown in Figure 4. The spikes 301 in the left corner of the example spectrum are low frequency current components caused by the AC network 40. The modulation frequency current components assessed by equation 2 are shown as the high spike 300 in the middle of the example spectrum. The correctness may be assessed by taking a squared sum of the measured currents in the high frequency range (in the example spectrum between 4k and 5k) and comparing that to an absolute value of the high spike.

In addition to e.g. the base frequency component caused by the AC network 40, other components may be visible. They may be caused by non-idealities in the AC network 40, such as phase and amplitude difference between the phases of the AC network 40. These may be visible in the low frequency spectrum as small spikes at multiples of the base frequency. Small spikes may be visible e.g. at 100Hz and 600Hz depending on the base frequency. In case such spikes exist and are too large in relation to the base frequency, e.g. more than a predetermined level, they could be suitably taken into account and/or e.g. a notification may be provided to a user or an operator of the system, for example.

According to an embodiment, after assessing values of one or more current components, e.g. as described above, all the determined components may be normalized into one single current value *I_{f}* to assess a temperature rise caused by these different frequency current(s) in the capacitor assembly C, Cₐ, C_{b} e.g. as follows: ${I}_{f} = \sqrt{{\left(\frac{{I}_{1}}{{F}_{f 1}}\right)}^{2} + {\left(\frac{{I}_{2}}{{F}_{f 2}}\right)}^{2} + {\left(\frac{{I}_{3}}{{F}_{f 3}}\right)}^{2} ⋯}$ (5) where:
*I_{f}* is the frequency compensated RMS ripple current
*Iᵢ* is the RMS value of a capacitor current component at frequency *fᵢ*
*F_{fi}* is a frequency correction factor at frequency *fᵢ*, provided e.g. by manufacturer a manufacturer of the capacitor assembly.

According to an embodiment, the frequency compensated RMS ripple current *I_{f}* is multiplied by a cooling coefficient *K_{cooling}* because of forced cooling if forced cooling is used. This term may be caused e.g. by a cooling fan blowing air to the capacitor assembly C, Cₐ, C_{b} or a liquid coolant flowing in the capacitor assembly C, Cₐ, C_{b} cooling structure which cools down the capacitor assembly C, Cₐ, C_{b} and may lever the effect of heating currents, for example. Coefficient *K_{cooling}* may be defined as: ${K}_{cooling} = \sqrt{\frac{{R}_{th , tot}}{{R}_{th , tot 0}}}$ (6) where:
*R_{th,tot}* is a thermal resistance of the capacitor assembly C, Cₐ, C_{b} when the forced cooling is in operation
*R*_{*th,tot*0} is a thermal resistance of the capacitor assembly C, Cₐ, C_{b} from core to ambient at a nominal load.

According to an embodiment, the values of the thermal resistances *R_{th,tot}* and *R*_{*th,tot*0} can be calculated or determined by or generally obtained from e.g. the electric power converter 10, 10a, 10b, 20 connected to the capacitor assembly C, Cₐ, C_{b}. Thermal resistances *R_{th,tot}* and *R*_{*th,tot*0} can be calculated as: ${R}_{th . tot} = {R}_{th core to case} + {R}_{th , case to ambient}$ (7a) ${R}_{th . tot 0} = {R}_{th core to case} + {R}_{th , case to ambient 0}$ (7b) where:
*R_{th,core to case}* is a value provided e.g. by a manufacturer of the capacitor assembly (or of the one or more capacitors of the capacitor assembly).

According to an embodiment, thermal resistances *R_{th,case to ambient}*, *R*_{*th,case to ambient*0} of the capacitor assembly C, Cₐ, C_{b} can then be determined by equations: ${R}_{th , case to ambient} = \frac{1}{{h}_{th , case} ∗ A}$ (8a) ${R}_{th , case to ambient 0} = \frac{1}{{h}_{th , case 0} ∗ A}$ (8b) where:
*A* is a capacitor surface area, provided e.g. by a manufacturer of the capacitor assembly (or of the one or more capacitors of the capacitor assembly)
*h_{th,case}* is a heat transfer coefficient when the forced cooling is in operation
*h*_{*th,case*0} is a heat transfer coefficient with zero velocity of coolant.

According to an embodiment, the heat transfer coefficient *h_{th,case}* may be generally of form: ${h}_{th , case} = a + b {\left(v+c\right)}^{d}$ (9) where:
*a, b, c, d* are values provided by e.g. by a manufacturer of the capacitor assembly or obtained by testing
*v* (or *vₐ*, *v_{b}*) is a wind speed or coolant speed coefficient around the capacitor assembly, or a corresponding coefficient.

Heat transfer coefficient *h*_{*th,case*0} may be calculated with equation 9 by setting *v* = 0.

According to an embodiment, an effective (total) current value *I_{A},* which can be used to calculate the temperature rise in the capacitor assembly, can be calculated as: ${I}_{A} = {K}_{cooling} ∗ {I}_{f}$ (10)

The total heating current value *I_{A}* may be converted into the temperature rise Δ*T* by equation: $Δ T = Δ {T}_{0} ∗ {\left(\frac{{I}_{A}}{{I}_{0}}\right)}^{2}$ (11) where:
*I*₀ is a nominal (rated) current value of the capacitor assembly.

According to an embodiment, the current factor *K_{R}* may then be calculated as: ${K}_{R} = {2}^{\frac{Δ {T}_{0} - Δ T}{10}}$ (12)

In addition to previously mentioned factors *K_{R}*, *Kᵥ* and *K_{T}*, there might be one or more additional and/or alternative factors, such as humidity factor *Kₕ*, vibration factor *K_{vib}* and/or one or more other factors *Kₓ.* Equation 1 could then be composed of any combination of such factors *K_{R}*, *Kᵥ, K_{T}*, *Kₕ, K_{vib}* and/or *Kₓ* depending e.g. on capacitor type and/or properties. As an example, such humidity factor *Kₕ* could be of form: ${K}_{h} = {\left(\frac{{RH}_{0}}{{RH}_{x}}\right)}^{n}$ (13) where
*RH₀* is a referece humidity, provided e.g. by the manufacturer of the capacitor assembly (or of the one or more capacitors of the capacitor assembly) or predetermined e.g. in an R&D phase of product development
*RHₓ* is measured humidity in operating environment of the capacitor assembly
*n* is an exponent, provided e.g. by the manufacturer of the capacitor assembly (or of the one or more capacitors of the capacitor assembly) or predetermined e.g. in an R&D phase of product development.

By inserting the applicable determined values into equation 1, the estimated lifetime (total lifetime) *Lₓ* of the capacitor assembly can be obtained. According to an embodiment, the instantaneous stress level of the capacitor assembly C, Cₐ, C_{b} can then be determined the on the basis of the determined estimated lifetime of the capacitor assembly and the predetermined designed lifetime of the capacitor assembly. According to an embodiment, the instantaneous stress level *S_{Instantaneous}* of the capacitor assembly C, Cₐ, C_{b} may be determined as a ratio of the determined estimated lifetime *Lₓ* of the capacitor assembly and the predetermined designed lifetime of the capacitor assembly, e.g. as: ${S}_{Instantaneous} = {L}_{R & D} / {L}_{x}$ (14) where:
*L_{R&D}* is the predetermined designed lifetime of the capacitor assembly.

Such instantaneous stress level *S_{Instantaneous}* of the capacitor assembly C, Cₐ, C_{b} may be generally indicative of how stressful a current operating point of the electric power converter system is for the capacitor assembly C, Cₐ, C_{b}. Consequently, the instantaneous stress level *S_{Instantaneous}* of the capacitor assembly C, Cₐ, C_{b} could be used for evaluating whether the current operating point of the electric power converter system should be changed, for example.

According to an embodiment, the predetermined designed lifetime *L_{R&D}* of the capacitor assembly may be suitably predetermined, e.g. in an R&D phase of product development, for the capacitor assembly in the intended use, for example. Term designed lifetime may thus generally refer to an intended (e.g. average) lifetime of the capacitor assembly that it remains functional, for example.

Because there are many variables in the equation which may be constantly changing due to the operation of the converter system, also the stress may vary continuously during such operation. Consequently, according to an embodiment, the stress calculation may be performed repeatedly, e.g. essentially continuously or at intervals, during the operation over a period of time.

According to an embodiment, the cumulative stress level of the capacitor assembly C, Cₐ, C_{b} over the period of time on the basis of the two or more instantaneous stress levels determined over the period of time may be determined from the beginning of the lifetime of the capacitor assembly. This kind of total cumulative stress *S_{cumulative}*, which may represent an average of all the stress values from the beginning of life of the capacitor assembly C, Cₐ, C_{b}, may be calculated as: ${S}_{cumulative} = \frac{{\sum }_{0}^{N} {S}_{instantaneous}}{N}$ (15) where
N is the number of instantaneous stress levels determined over the period of time.

Such total cumulative stress *S_{cumulative}* of the capacitor assembly C, Cₐ, C_{b} may be generally indicative of how stressful the total operation of the electric power converter system has been for the capacitor assembly C, Cₐ, C_{b}. Consequently, the total cumulative stress *S_{cumulative}* of the capacitor assembly C, Cₐ, C_{b} could be used for evaluating whether the operation of the electric power converter system should be changed, for example.

According to another embodiment, the cumulative stress level of the capacitor assembly over the period of time may be determined for a desired time window for stress values. This kind of cumulative stress value may be referred to as a recent stress and may be determined over any time period defined e.g. by a user or an operator, e.g. the last day or last week average stress until this moment. This kind of recent cumulative stress *S_{recent}* may be calculated as: ${S}_{recent} = \frac{{\sum }_{t = - M}^{t = t} {S}_{instantaneous}}{t - M}$ (16) where
M is the number of instantaneous stress levels determined over the period of time from t-M to t.

Such recent cumulative stress *S_{recent}* of the capacitor assembly C, Cₐ, C_{b} may be generally indicative of how stressful the recent operation of the electric power converter system for the desired time window has been for the capacitor assembly C, Cₐ, C_{b}. Consequently, the recent cumulative stress *S_{recent}* of the capacitor assembly C, Cₐ, C_{b} could be used for evaluating whether the operation, such as a drive profile, of the electric power converter system should be changed, for example.

According to an embodiment, the obtained stress level S, e.g. *S_{Instantaneous}*, *S_{cumulative}* or *S_{recent}*, may then be suitably evaluated. According to an embodiment, the obtained stress level S may be compared to two or more predetermined stress level values and/or value ranges to determine whether the stress level S is e.g. low or high and/or to determine how low or how high the stress level S is.

According to an embodiment, such predetermined stress level values and value ranges could be defined e.g. as:
1. For *S* > 1.0, stress is High
2. For *S* ~ 1, stress is about Nominal
3. For *S* < 1.0, stress is Low

Instead of three predetermined stress level values and/or value ranges, there could be only two, e.g. high and low, or there could be more than three predetermined stress level values and/or value ranges, e.g. corresponding to very low, low, nominal, high and very high stress. The number of such predetermined stress level values and/or value ranges could be increased in a corresponding manner. Moreover, the specific limits for each such value and/or value range could be suitably selected e.g. application specifically or by any other appropriate manner.

Thus, the purpose is not necessarily to calculate or define the stress level precisely but instead it is possible to obtain an approximate or sufficiently indicative value thereof. The determined stress level S of the capacitor assembly could be used e.g. for only giving an idea about how stressful the environment for the capacitor assembly C, Cₐ, C_{b} is and may thus be an approximate value.

According to an embodiment, e.g. one or more predetermined threshold levels of stressful usage of the capacitor assembly C, Cₐ, C_{b} may be defined. Such threshold levels could correspond to the predetermined stress level value(s) and/or value(s) defining the predetermined stress level value range(s), for example, or they could be defined separately. Then, upon the determined stress level S reaching and/or exceeding such a predetermined threshold level, a corresponding action may be taken. Such an action may include e.g. sending an alert to a user or an operator of the system and/or controlling the electric power converter system, or one or more of its components, to reduce the stress caused to the capacitor assembly C, Cₐ, C_{b} in the system.

As an example, e.g. the following predetermined threshold levels could be used for alerting the user or an operator of the system:
1. For *S* > 1.0, a high stress warning may be presented to the user. Moreover, e.g. ways to decrease the stress may be presented.
2. For *S* > 3.0, a very high stress warning may be presented to the user and preferably logged to system. Ways to decrease stress may be presented.
3. For *S* > 5.0, extremely high stress warning may be presented to the user and preferably logged to system. Ways to decrease stress may be presented and optionally a high stress level warning could be sent to external service to react to the situation.

Given that the stress level value S should exceed e.g. 1 may be generally an indication that the capacitor assembly is being stressed more than statistically designed, for example. In addition to or alternatively to notifying the user with a warning, some actions can be proposed as a remedy to the problem. Stress thresholds levels for any actions described herein or combinations thereof can also vary depending on the application and/or system characteristics. The example threshold levels *S* > 1.0, *S* > 3.0 and S > 5.0 could thus be defined to be different depending on the application, for example.

As an example, depending on e.g. which of the possible stress contributing factors, voltage, current or ambient temperature is the most affecting to the stress level, proposals to the user could be presented according to one or more of the following examples:
1. In case of high *K_{T}*, cooling can be increased by increasing fan speed, coolant flow in the system and/or some other method to increase cooling.
2. In case of high *K_{R},* working point of the electric power converter operating as an inverter can be adjusted to be less stressful in form of controlling cosine phi, modulation index and/or limiting output current *I_{S}.* Also by increasing cooling can be a remedy for the situation. In some situations, electricity quality in the AC network may also contribute to this factor.
3. In case of high *K_{V},* the working point of the device could be adjusted to be less stressful in form of controlling incoming power of the drive.

Moreover, instead of presenting such proposals to the user or operator of the system, it is also possible to directly or indirectly control the electric power converter system, or one or more of its components, such as the first electric power converter 10, 10a, 10b and/or the second electric power converter 20 and/or the brake chopper 50, accordingly to reduce the stress.

According to an embodiment, the determination of the stress level S could be performed as described in the following example. It should be noted, however, that the example given could be modified in several ways and one or more of the steps described could be omitted or replaced and/or additional steps could be included.
1. Initialize a calculation logic with required parameters once at the beginning including one or more of the following:
   1. *C*₀ is the nominal capacitance of the DC-link
   2. *V*₀ is the nominal operating voltage of the capacitor assembly
   3. *T*₀ is the nominal ambient temperature of the capacitor assembly
   4. *L*₀ is the nominal lifetime of the capacitor assembly
   5. *I*₀ is the rated ripple current of the capacitor assembly
   *6.* Δ*T*₀ is the core to ambient temperature difference in the capacitor assembly at nominal load
   *7. R_{BR}* is the resistance of the brake resistor
   8. *L_{R&D}* is the predetermined designed lifetime of the capacitor assembly
   9. Modulation method
   10. Scaling factor from fans rotation speed to wind speed or cooling speed
   11. Forced cooling equation offset *a*
   12. Forced cooling equation coefficient b
   13. Forced cooling equation exponent *d*
   14. Forced cooling equation summation term *c*
2. Continuously repeat the following cycle:
   a. Record DC-voltage *Vₓ* with sufficient sampling rate and time. Record also stator current, *I_{S}*, modulation index *M*, cosine phi *cos*(φ), pulse ratio *d* of brake chopper, fan speed and air input temperature *T_{X}* after recording of multiple samples DC-voltage. If any other inverter or line converter is connected to the same capacitor assembly, get also their modulation method, modulation index *M*, output current *I_{S}* and cosine phi *cos*(*φ*)*.* Note that it is possible to only measure, only calculate or perform a combination of both methods to get current values by different sources.
   b. Calculate Fast Fourier Transform (FFT) from DC voltage recording, if applicable.
   c. Get frequency current components of different frequencies in the capacitor assembly by dividing DC-voltage FFT values by an impedance of the capacitor assembly, if applicable.
   d. Calculate modulation current in the capacitor assembly caused by motor inverter by utilizing the modulation index *M*, output current *I_{S},* cosine phi *cos*(*φ*)*,* and equation (3) or (4) for all inverter devices connected to the DC-link, if applicable.
   e. Calculate the current caused by the brake chopper, if applicable.
   f. Calculate *I_{f}* from all the different current components.
   g. Calculate the cooling factor *K_{f}* based on the fan speed or cooling state.
   h. Scale effective current value by the cooling factor. *I_{A}* = *K_{cooling} * I_{f}*
   i. Calculate the temperature rise Δ*T* in the capacitor assembly caused by current *I_{A}*.
   j. Calculate the ripple current lifetime factor *K_{R}* based on the temperature rise *ΔT.*
   k. Calculate from the air in temperature or coolant the capacitor assembly's ambient temperature lifetime factor *K_{T}.*
   l. Calculate *K_{V}.*
   m. Calculate lifetime *Lₓ* of the capacitor assembly based on, *K_{R}, K_{T}* and/or *K_{V}.*
   n. Calculate instant stress *Sᵢₙₛₜₐₙₜₐₙₑₒᵤₛ* based on *Lₓ,* and *L_{R&D}* .
   o. Update *S_{cumulative}* and/or *S_{recent}* based on *Sᵢₙₛₜₐₙₜₐₙₑₒᵤₛ*.
   p. Repeat steps from the beginning to update *Sᵢₙₛₜₐₙₜₐₙₑₒᵤₛ* to match current operating point of the electric power converter system.

According to an embodiment, an apparatus for estimating a stress level of a capacitor assembly is provided. The apparatus comprises means configured to obtain at least one value of at least one operating parameter related to the capacitor assembly, means configured to determine an estimated lifetime of the capacitor assembly on the basis of the obtained at least one value and means configured to determine an instantaneous stress level of the capacitor assembly on the basis of the determined estimated lifetime of the capacitor assembly and a predetermined designed lifetime of the capacitor assembly. According to an embodiment, the apparatus further comprises means configured to carry out the functionality of any of the embodiments described herein. According to an embodiment, an arrangement is provided which arrangement comprises a capacitor assembly and apparatus for estimating the stress level of the capacitor assembly. According to an embodiment, the arrangement further comprises measuring means configured to measure the at least one value of at least one operating parameter related to the capacitor assembly.

Possible advantages provided by the various embodiments described herein, and combinations thereof, may include that the implementation does not necessarily require any specific mode of operation of the electric power converter system or of its components, such as the first electric power converter 10, 10a, 10b and/or the second electric power converter 20 and/or the brake chopper 50. Thus, there is no need to interfere the normal operation of the electric power converter system or of its components in any specific way, for example. The solution according to the embodiments described herein can be used for assessing how stressful the operation has been for the capacitor assembly and if there is e.g. a need for a premature capacitor replacement compared to a service timetable, for example. Also, the solution according to the embodiments described herein may help to assess if the capacitor assembly does not yet need to be replaced based on the service timetable, in case stress has not been high. This can improve the reliability of the electric power converter system but may also decrease maintenance costs associated with the capacitor assembly replacement.

The arrangement 100, such as a control and/or monitoring arrangement, and/or other means configured to implement any one of the above embodiments, or a combination thereof, may be implemented as one unit or as two or more separate physical units that are configured to implement at least part of the functionality of the various embodiments. Herein the term 'unit' generally refers to a physical or logical entity, such as a physical device or a part thereof or a software routine.

Generally, the arrangement 100 and/or any other means for implementing at least part of the functionality according to any one of the embodiments described herein may be implemented at least partly by means of one or more computers or corresponding digital signal processing (DSP) equipment provided with suitable software, for example. Such a computer or digital signal processing equipment preferably comprises at least a working memory (RAM) providing storage area for arithmetical operations, and a central processing unit (CPU), such as a general-purpose digital signal processor. The CPU may comprise a set of registers, an arithmetic logic unit, and a control unit. The CPU control unit is controlled by a sequence of program instructions transferred to the CPU from the RAM. The CPU control unit may contain a number of microinstructions for basic operations. The implementation of microinstructions may vary depending on the CPU design. The program instructions may be coded by a suitable programming language, which may be a high-level programming language, such as C, Java, etc., or a low-level programming language, such as a machine language, or an assembler. The computer may also have an operating system which may provide system services to a computer program written with the program instructions. The computer or other apparatus implementing the various embodiments, or a part thereof, may further comprise suitable input means for receiving e.g. measurement and/or control data, and output means for outputting e.g. control or any other data. It is also possible to use a specific integrated circuit or circuits, such as application-specific integrated circuits (ASIC), digital signal processing devices (DSPD), programmable logic devices (PLD), field-programmable gate arrays (FPGA) and/or discrete electric components and devices for implementing the functionality according to any one of the embodiments.

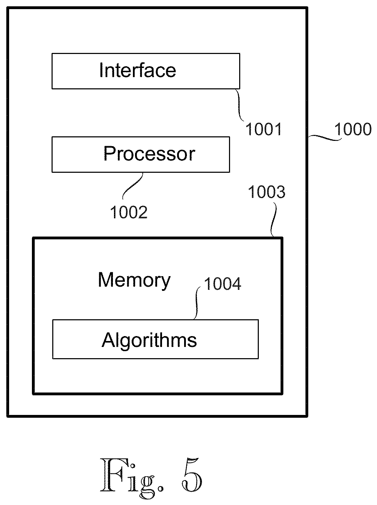

Figure 5 is a simplified block diagram illustrating some units for an apparatus (device, equipment, system) 1000 configured to perform at least some functionality of the arrangement 100, such as a monitoring and/or control arrangement, or generally any corresponding apparatus. In the illustrated example, the apparatus 1000 comprises one or more interface (IF) entities 1001, such as one or more user interfaces and/or data interfaces, and one or more processing entities 1002 connected to various interface entities 1001 and to one or more memories 1003. The one or more interface entities 1001 may be entities for receiving and/or transmitting information, such as communication interfaces comprising hardware and/or software for realising communication connectivity according to one or more communication protocols, or for realising data, e.g. measuring or operational data, storing and fetching, and/or for providing user interaction via one or more user interfaces. A processing entity 1002 is capable to perform calculations and configured to implement at least part of functionalities and/or operations described above, with corresponding algorithms 1004 stored in the memory 1003. The processing entity 1002 may include one or more processors, controllers, control units, micro-controllers, etc. configurable to carry out e.g. embodiments, examples, implementations and/or operations described above. Generally, a processor may be a central processing unit, but the processor entity 1002 may be an additional operation processor or a multicore processor or a microprocessor, for instance. A memory 1003 may be usable for storing a computer program code required for one or more functionalities/operations described above, that is, the algorithms 1004 for implementing the functionality/operations described above. The memory 1003 may also be usable for storing, at least temporarily, other possible information required for one or more functionalities/operations described above. The memory 1003 may comprise a data buffer that may, at least temporarily, store for example measurement and/or operational data and/or information received as a user input and/or from another entity. An apparatus comprising the means for providing any embodiment described herein may be implemented at least partly by means of such apparatus 1000 as exemplified in Figure 5.

The various embodiments described herein can be implemented in existing electric power converter systems and components thereof and/or by using separate dedicated elements or devices in a centralized or distributed manner. Present electric power converter devices may comprise processors and memory, e.g. in a control arrangement of the converter device, that can be utilized in the functions according to the various embodiments described above. Generally, many electric devices, such as electric power systems, and components thereof, such as intelligent electronic devices, may comprise processors and memory that may also be utilized in implementing the functionality according to the various embodiments described herein. Thus, at least some or all modifications and configurations required for implementing an embodiment in existing converter devices may be performed as software routines, which may be implemented as added or updated software routines. If at least part of the functionality of any of the embodiments is implemented by software, such software may be provided as a computer program product comprising computer program code which, when run on a computer, causes the computer or corresponding arrangement to perform the functionality according to the embodiments as described herein. Such a computer program code may be stored or generally embodied on a computer readable medium, such as suitable memory, e.g. a flash memory or an optical memory, from which it is loadable to the unit or units executing the program code. In addition, such a computer program code implementing any of the embodiments may be loaded to the unit or units executing the computer program code via a suitable data network, for example, and it may replace or update a possibly existing program code. An embodiment may provide a computer program embodied on any client-readable distribution/data storage medium or memory unit(s) or article(s) of manufacture, comprising program instructions executable by one or more processors/computers, which instructions, when loaded into an apparatus, constitute the control arrangement, or any corresponding unit or an entity providing corresponding functionality, or at least part of the corresponding functionality. Programs, also called program products, including software routines, program snippets constituting "program libraries", applets and macros, can be stored in any medium and may be downloaded into an apparatus. In other words, each or some or one of the possible units/sub-units and/or algorithms for one or more functions/operations described above, for example by means of any of Figures 1 to 5 and any combination thereof, may be an element that comprises one or more arithmetic logic units, a number of special registers and control circuits.

It will be obvious to a person skilled in the art that, as the technology advances, the inventive concept can be implemented in various ways. The invention and its embodiments are not limited to the examples described above but may vary within the scope of the claims.

## Claims

1. A computer implemented method for estimating a stress level of a capacitor assembly, the method comprising:
a) obtaining at least one value of at least one operating parameter related to the capacitor assembly;
b) determining an estimated lifetime of the capacitor assembly on the basis of the obtained at least one value; and
c) determining an instantaneous stress level of the capacitor assembly on the basis of the determined estimated lifetime of the capacitor assembly and a predetermined designed lifetime of the capacitor assembly.

2. A computer implemented method as claimed in claim 1, further comprising:
repeating steps a) to c) two or more times over a period of time; and
determining a cumulative stress level of the capacitor assembly over the period of time on the basis of the two or more instantaneous stress levels determined over the period of time.

3. A computer implemented method as claimed in claim 2, wherein steps a) to c) are repeated essentially continuously or at predetermined intervals over the period of time.

4. A computer implemented method as claimed in any one of claims 1 to 3, wherein the determining of the estimated lifetime of the capacitor assembly is based on a predetermined nominal lifetime of the capacitor assembly and at least one stress factor based on the at least one operating parameter.

5. A computer implemented method as claimed in claim 4, wherein the at least one stress factor comprises a temperature factor and the at least one operating parameter comprises at least one operating temperature parameter of the capacitor assembly.

6. A computer implemented method as claimed in claim 4 or 5, wherein the at least one stress factor comprises a current factor and the at least one operating parameter comprises at least one operating current parameter of the capacitor assembly.

7. A computer implemented method as claimed in claim 4, 5 or 6, wherein the at least one stress factor comprises a voltage factor and the at least one operating parameter comprises at least one operating voltage parameter of the capacitor assembly.

8. A computer implemented method as claimed in any one of claims 1 to 7, wherein the capacitor assembly comprises one or more capacitors.

9. A computer implemented method as claimed in any one of claims 1 to 8, wherein the capacitor assembly is a capacitor assembly of a DC link circuit.

10. A computer implemented method as claimed in any one of claims 1 to 9, further comprising controlling an apparatus comprising the capacitor assembly or connected to the capacitor assembly on the basis of the determined stress level of the capacitor assembly.

11. A computer program product comprising program instructions which, when run by a computing apparatus, cause the computing apparatus to carry out a method according to any one of claims 1 to 10.

12. An apparatus for estimating a stress level of a capacitor assembly, the apparatus comprising:
means configured to obtain at least one value of at least one operating parameter related to the capacitor assembly;
means configured to determine an estimated lifetime of the capacitor assembly on the basis of the obtained at least one value; and
means configured to determine an instantaneous stress level of the capacitor assembly on the basis of the determined estimated lifetime of the capacitor assembly and a predetermined designed lifetime of the capacitor assembly.

13. An apparatus according to claim 12, further comprising means configured to carry out a method according to any one of claims 2 to 9.

14. An arrangement comprising:
a capacitor assembly; and
an apparatus according to claim 12 or 13.

15. An arrangement as claimed in claim 14, the arrangement further comprising measuring means configured to measure the at least one value of at least one operating parameter related to the capacitor assembly.
